# EUROPÄISCHE PATENTANMELDUNG

(11) **EP 2 184 819 A2**
(43) Veröffentlichungstag der Anmeldung: **12.05.2010**
(21) Anmeldenummer: 09014857.8
(22) Anmeldetag: 25.11.2004
(51) Int. Cl.: H01S 5/183, H01S 5/34, H01S 5/343, H01S 5/04

(54) **Optisch gepumpte Halbleitervorrichtungen zur Erzeugung von Strahlung und deren Herstellung sowie Verfahren zur Kompensation von Verspannungen in den darin eingesetzten Schichtfolgen**

(30) Priorität: 25.11.2003 DE 10355357
(62) Teilanmeldung aus: 04802833.6
(71) Anmelder: PHILIPPS-UNIVERSITÄT MARBURG, 35037 Marburg (DE)
(72) Erfinder: Stolz, Wolfgang Dr., 35041 Weimar/Lahn (DE); Lutgen, Stephan, 93047 Regensburg (DE)
(74) Vertreter: Buchhold, Jürgen

(57) **Zusammenfassung**

Verfahren zur Herstellung verspannungskompensierender Halbleiterschichten, sowie dessen Verwendung zur Herstellung von verspannungskontrollierten Halbleiterschichtsystemen und zur Herstellung von optisch gepumpten Halbleitervorrichtungen zur Erzeugung von Strahlung, vorzugsweise langwelliger Strahlung.

## Beschreibung

Die vorliegende Erfindung beschreibt die Herstellung und Realisierung von langwelligen MILOS-Scheibenlasern (MILOS=Monolithic Integrated Lateral Optical Pumped Semiconductor), extern optisch Barriere/Quantenfilm-gepumpten und elektrisch gepumpten Scheibenlasern mittels Epitaxie (MBE, MOMBE, GSMBE, MOVPE) sowie ein Verfahren zur Kompensation der Kompensation von Verspannungen der darin eingesetzten Schichten.

### Stand der Technik

Die hier diskutierten optisch gepumpten Halbleiterlaserstrukturen bestehen im wesentlichen aus einer Einkoppelschicht, einem aktiven Bereich aus Quantenfilmen, die so angeordnet sind, dass sie einen optimalen Überlapp zu dem Lichtfeld des Pumplasers aufweisen, und einem epitaktischen (lambda/4) Vielschichtspiegel (Distributed Bragg-Reflektor (DBR)), der das emittierte Licht der Quantenfilme zurückspiegelt und somit in dem Laserresonator den hochreflektierenden Endspiegel darstellt.

Für die darin bekannterweise verwendeten Schichtstrukturen wird mit zunehmender Emissionswellenlänge und damit zunehmender Verspannung der Einbau verspannungskompensierender Schichten immer wichtiger. Diese kompressive Verspannung muss in den hier zur Diskussion stehenden Schichtfolgen, die zu einer effizienten Absorption des Pumplichtes im Bereich von z. B. 5 bis 25 oder mehr aktive Quantenfilmpaketen enthalten muss, durch zugverspannte Schichten kompensiert werden.

Für die Realisierung von langwelligen Scheibenlasern > 1000nm werden für die Lichterzeugung kompressiv verspannte InGaAs-Quantenfilme mit In-Konzentrationen mit typ. > 18% und Schichtdicken mit typ. < 10nm benötigt. Diese können z. B. bei MOVPE-Wachstumstemperaturen von > 600 C mit guter Qualität nur für Wellenlängen bis ca.1000nm hergestellt werden, da oberhalb der kritischen Schichtdicke eine Relaxation der verspannten Einzelschichten einsetzt.

Eine weitere Erhöhung der kritischen Schichtdicke kann durch eine geringerer Energiezufuhr, d. h. z. B. durch eine niedrigere Wachstumstemperatur T < 600°C erzielt werden.

### Nachteil im Stand der Technik

Die bislang in der MOVPE eingesetzten AsH3-und PH3-Gruppe-V-Gasquellen weisen bei dieser geringen Energiezufuhr, d. h. z. B. in Form einer Wachstumstemperatur von T < 600°C sehr schlechte Zerlegungseigenschaften auf.

Aufgrund der geringen Zerlegungseffizienz von AsH3-und PH3-Gruppe-V-Gasquellen in der MOVPE bei diesen niedrigen Temperaturen ist der Einsatz alternativer Quellen für As und P notwendig.

### Aufgabe

Aufgabe der vorliegenden Erfindung ist es daher ein Verfahren zur Kompensation von Verspannungen in den Schichtfolgen optisch gepumpter Halbleitervorrichtungen zur Erzeugung von Strahlung, insbesondere langwelliger Strahlung unter Verwendung der oben benannten Epitaxie-Verfahren vorzusehen.

Mit den durch dieses Verfahren hergestellten Schichtfolgen können qualitativ hochwertigere optisch gepumpte Halbleitervorrichtungen und generell besser verspannungskontrollierte Halbleitermehrfachschichtstrukturen erzeugt werden.

### Lösung der Aufgabe

Überraschenderweise wurde dazu gefunden, dass in Epitaxieverfahren bei geringer Energiezufuhr, z. B. bei MOVPE und bei geringen Temperaturen, d. h. von T < 600°C dann eine vorteilhafte Verspannungskompensation erreicht wird, wenn neben den bekannten N-Quellen (Hydrazine, wie 1, 1-Dimethylhydrazin ((CH₃)₂NNH₂, UDMHy) oder auch Tertiärbutylhydrazin (t-C₄H₉HN-NH₂)) und bekannten Sb-Quellen unter Verwendung von TBAs- und/oder TBP-Quellen (Tertiärbutylarsin, d. h. (t-C₄H₉AsH₂), bzw. Tertiärbutylphosphin (t-C₄H₉PH₂, TBP)) oder entsprechenden Arsenalkyl- und Alkylphosphin-Verbindungen Schichtenn - innerhalb der in ihrer einzelnen oder gemeinsamen Spannung zu kompensierenden Schichten - , z. B. aus Ga(PAs) oder/und Ga(NAs) oder/und (Galn)(NAs) bei der Epitaxie abgeschieden werden. Besonders vorteilhaft sind dabei derartige Schichten, welche zusätzlich als zugverspannte Schichten ausgeführt sind.

Neben InGaAs-Quantenfilmen können mit entsprechenden N-Quellen (Hydrazin) und Sb-QuellenlnGaAsN, InGaAsSb, InGaAsNSb, GaAsN, AlAsN, GaAsSb, AlAsSb, GaAsP-Schichten als Quantenfilm- und Barrierenstrukturen auf GaAs hergestellt werden. Damit können insbesondere in der MOVPE folgende GaAs-basierende Wellenlängen für Scheibenlaser/VNECSEL zugänglich gemacht werden (VECSEL=Vertical External Cavity Surface Emitting Laser):

| Quantenfilme : | Wellenlängen : |
|---|---|
| InGaAs | < 1000nm (Standardquellen) |
| InGaAs | < 1100nm (TBAs, TBP) |
| InGaAsN | < 1300nm/1500nm (TBAs, TBP) |
| InGaAsNSb | < 2000nm (TBAs, TBP, Sb-Quellen) |

Das Design je nach Wellenlänge ist insbesondere für effiziente Scheibenlaserstrukturen kritisch. Mit geeigneten Strukturen sind die zwei (fundamentalen) Wellenlängen 1050nm (frequenzverdoppelt grün) und 1260nm (frequenzverdoppelt rot) realisierbar. Diese Wellenlängen eröffnen neben den bisher bekannten Wellenlängen u. a. den ganzen sichtbaren Wellenlängen durch resonatorinterne Frequenzverdopplung.

Bei der Epitaxie von Scheibenlasern bei 1050nm Emissionswellenlänge kann eine erhöhte In-Konzentration bei niedrigen Wachstumstemperaturen von T < 600°C mit den oben genannten TBAs-Quellen für die InGaAs-Quantenfilme zur Lichterzeugung und TBP-Quellen für die verspannungskompensierenden Barrierenschichten in der aktiven Schicht realisiert werden. Bei dieser Wellenlänge ist i. d. R. noch keine Verspannungskompensation der hochaluminiumhaltigen Schichten, die insbesondere in den Braggreflektoren zum Einsatz kommen, notwendig.

Insbesondere für Scheibenlaser bei längeren Wellenlängen ist dann i. d. R. auch eine Kompensation der Verspannung des Braggspiegels bei niedrigen Wachstumstemperaturen für die unterschiedlichen Materalien (typ. AlAs-, GaAs-, bzw. AlₓGa₁₋ₓAs-Schichten mit varierendem Al-Gehalt) mit Brechungsindexsprung vorteilhaft, da bereits während der Epitaxie diese Materialkombinationen unterschiedliche thermische Ausdehnungekoeffizienten haben und zu einer Materialdegradation führen können.

Dazu gibt es verschiedene Verspannungskompensationskonzepte, bei der hier insbesondere in den hochaluminiumhaltigen AlGaAs/AlAs-Schichten durch geringe Konzentrationen von P die leicht kompressive Verspannung durch das Aluminium tensil kompensiert werden kann. Die Barrierenschichten müssen je nach optischer Absorptionswellenlänge und -konzept für einen effizienten Betrieb sehr kritisch untersucht werden. Als Absorptionsschicht kann neben GaAsP und AlGaAs-Schichten für Absorptionswellenlängen < 900nm auch InGaAsN oder GaAsN mit Absorptionswellenlängen > 900nm erfindungsgemäß hergestellt werden. Dabei ist je nach Materialkombination auf das ausreichende Ladungsträgerkonfinement in Leitungs- und Valenzband zu achten. Insbesondere für InGaAsN-Quantenfilme zur Lichterzeugung ist ein ausreichendes Löcherkonfinement durch den Einsatz von GaAsP/AlGaAs-Schichten im Design für einen effizienten Laserbetrieb notwendig.

Das erfindungsgemäße Verfahren ist insbesondere für Scheibenlaser-Varianten für höhere Wellenlängen von großem Vorteil. Die Herstellung solcher Scheibenlaser sind aufgrund der Frequenzverdopplung und entsprechender Farbzuordnung insbesondere im Bereich von 1260 nm wirtschaftlich sehr relevant.

Für die Schichtstrukturen wird mit zunehmender Emissionswellenlänge und damit zunehmender Verspannung der Einbau verspannungskompensierender Schichten immer wichtiger. Diese kompressive Verspannung muss in den hier zur Diskussion stehenden Schichtfolgen, die zu einer effizienten Absorption des Pumplichtes im Bereich von z. B. 5 bis 25 oder mehr aktive Quantenfilmpaketen enthalten muss, durch zugverspannte Schichten kompensiert werden. Hierzu kann man im aktiven Bereich entweder zugverspanntes Ga(PAs) einsetzen, wenn man mit einer Pumpwellenlänge unterhalb von 900 nm anregen möchte, oder zugverspanntes Ga(NAs) bzw. zugverspanntes (Galn)(NAs) einsetzen, wenn man mit längeren Pumpwellenlängen arbeiten möchten. Aufgrund des verbesserten Zerlegungsverhaltens lassen sich diese Schichtstrukturen kontrollierter, mit größerer lateraler Homogenität und präziser herstellen.

Ein einzelnes Quantenwellpaket kann dabei aus einem aber auch aus zwei Quantenfilmen bestehen.

Je größer die Emissionswellenlänge wird desto größer müssen auch die Schichtdicken der DBR-Struktur (Schichtaufbau aus lamda/4-Schichten) werden. Darüber hinaus wird der Unterschied des Brechungsindizes zwischen z. B. AlAs und GaAs mit zunehmender Wellenlänge kleiner, dies bedeutet, dass zur Erzielung eines gleich hohen Reflektionsgrades eine höhere Anzahl von DBR-Schichtpaaren abgeschieden werden muss. Da mit zunehmender Schichtdicke und Anzahl der der DBR-Paare auch für diese Struktur die integrale elastische Verspannung zunimmt, muss man auch für den DBR-Teil des Lasers eine Verspannungskompensation einbauen. Um die kompressive Verspannung des (AlGa)As-Teils zu kompensieren kann man einmal durch Zugabe von P-in diese Schicht die Verspannung abbauen (DBR-Aufbau (Al (grosse Konz. ) Ga) (PAs)/ (Al (klein Konz. ) Ga) As). Zum anderen kann man auch die kompressive Verspannung des (Al (gross) Ga) As durch zugverspanntes Ga(PAs) oder auch zugverspanntes(Al (klein) Ga) (PAs) kompensieren.

Die erfindungsgemäßen optisch gepumpten Halbleitervorrichtungen zur Erzeugung von Strahlung weisen daher zur Verspannungskompensation entsprechende zug- oder/und kompressionsverspannte Halbleiterschichten auf, welche vorzugsweise durch die Verwendung der oben genannten TBAs- oder/und TBP-Quellen in den ansonsten bekannten Expitaxie - insbesondere MOVPE - Verfahren erzeugt wurden.

## Patentansprüche

1. Halbleiter-Schichtfolge, die als Licht erzeugende Schicht wenigstens einen Quantenfilm und die mindestens eine verspannungskompensierende Schicht für die umgebende oder umgebenden Schichte(n) enthält, wobei die verspannungskompensierende Schicht eine zug- und/oder kompressionsverspannte Halbleiterschicht ist, die Arsen und/oder Phosphor aus TBAs- und/oder TBP-Quellen enthält, **dadurch gekennzeichnet, dass** der Quantenfilm aus InGaAsN oder InGaAsNSb und die verspannungskompensierende Schicht aus Ga(NAs) oder/und (Galn)(NAs) besteht.

2. Halbleiterschichtfolge nach Anspruch 1, **dadurch gekennzeichnet, dass** die Halbleiterschichtfolge mittels metallorganischer Gasphasenepitaxie (MOVPE) zwischen 300°C und 600°C erhältlich ist.

3. Halbleiterschichtfolge nach einem der Ansprüche 1 oder 2, **dadurch gekennzeichnet, dass** die verspannungskompensierende Schicht innerhalb der in ihrer einzelnen oder gemeinsamen Spannung zu kompensierenden Schichten abgeschieden ist.

4. Halbleiter-Schichtfolge nach einem der Ansprüche 1 bis 3, **dadurch gekennzeichnet, dass** sie einen aktiven Bereich aufweist und eine oder mehrere der zug- und/oder kompressionsverspannten Halbleiterschicht(en) in diesem aktiven Bereich angeordnet ist (sind).

5. Halbleiter-Schichtfolge nach einem der Ansprüche 1 bis 4, **dadurch gekennzeichnet, dass** mindestens eine der zug- und/oder kompressionsverspannten Halbleiterschichten im Bereich der als Reflektor oder Ein- oder Vielschichtspiegel aufgeführten Halbleiterschichten angeordnet ist.

6. Optisch gepumpte Halbleitervorrichtung zur Erzeugung von Strahlung, **dadurch gekennzeichnet, dass** sie eine oder mehrere der Halbleiter-Schichtfolgen nach einem der Ansprüche 1 bis 5 aufweist.

7. Halbleitervorrichtung nach Anspruch 6, **dadurch gekennzeichnet, dass** sie mindestens ein Quantenwellpaket aufweist, welches ein oder zwei Quantenfilme aufweist.

8. Halbleitervorrichtung nach einem der Ansprüche 6 oder 7, **dadurch gekennzeichnet, dass** sie 5 bis 25 Quantenwellpakete aufweist.

9. Verfahren zur Herstellung von Halbleiter-Schichtfolgen nach einem der Ansprüche 1 bis 5, **dadurch gekennzeichnet, dass** die verspannungskompensierende Schicht durch metallorganische Gasphasenepitaxie (MOVPE) bei einer Temperatur von 300°C bis 600°C und unter Verwendung von TBAs-Quellen oder/und TBP-Quellen erhalten und zug- oder/und kompressionsverspannt wird.

10. Verfahren nach Anspruch 8, **dadurch gekennzeichnet, dass** die verspannungskompensierende Schicht innerhalb der in ihrer einzelnen oder gemeinsamen Spannung zu kompensierenden Schichten abgeschieden wird.

11. Verfahren nach Anspruch 8 oder 9, **dadurch gekennzeichnet, dass** die umgebende Schicht eine kompressionsverspannte Halbleiterschicht ist.
